# EUROPEAN PATENT APPLICATION

(11) **EP 1 942 534 A2**
(43) Date of publication of application: **09.07.2008**
(21) Application number: 07150397.3
(22) Date of filing: 21.12.2007
(51) Int. Cl.: H01L 45/00, C25D 9/04

(54) **Method of forming a phase change layer by electro-chemical deposition and manufacturing of a storage node and a phase change memory device using the method**

(30) Priority: 02.01.2007 KR 20070000308
(71) Applicant: Samsung Electronics Co., Ltd., Suwon-si Gyeonggi-do 443-742 (KR)
(72) Inventor: Kang, Youn-seon, Gyeonggi-do (KR); Oh, Seung-jin, Gyeonggi-do (KR); Shin, Woong-chul, Gyeonggi-do (KR); Back, Kae-dong, Gyeonggi-do (KR)
(74) Representative: Greene, Simon Kenneth

(57) **Abstract**

Provided are a method of forming a phase change layer, and methods of manufacturing a storage node, and a phase change memory device using the method. The method of forming a phase change layer uses an electro-chemical deposition (ECD) method, in particular it includes forming an electrolyte (12) by mixing a solvent and precursors, each precursor containing an element of the phase change layer, dipping an anode plate (14) and a cathode plate (16) in the electrolyte to be spaced apart from each other, wherein the cathode plate is a substrate on which the phase change layer is to be deposited, setting deposition conditions of the phase change layer, and supplying a voltage between the anode plate and the cathode plate.

## Description

### BACKGROUND

Example embodiments relate to a method of manufacturing a semiconductor memory device. Other example embodiments relate to a method of forming a phase change layer, a method of manufacturing a storage node using the method of forming the phase change layer, and a method of manufacturing a phase change memory device using the method of manufacturing the storage node.

The molecular structure of a phase change material may be in a crystalline state or amorphous state depending on its temperature. When a phase change material is crystalline, the resistance of the phase change material may be relatively low. When the phase change material is amorphous, the resistance of the phase change material may be relatively high.

A phase change memory device records data using the above characteristics of the phase change material. A phase change memory device may include a transistor, and a storage node that is electrically connected via a contact plug to a source region or a drain region of the transistor. A phase change layer may be included in the storage node.

Ge₂Sb₂Te₅ (GST) may be a well-known material used to form a phase change layer. A GST layer may be formed using a physical vapor deposition (PVD) method, a metal organic chemical vapor deposition (MOCVD) method and/or an atomic layer deposition (ALD) method. However, when a GST layer is formed using a PVD method, the growth of the GST layer may be difficult to control, and the GST layer may not be dense. For example, in order to realize a highly integrated memory device, the phase change layer may be formed in a confined structure. However, forming the GST layer in a confined structure using the PVD method may be difficult.

Accordingly, in order to overcome the problem described above, a GST layer may be alternatively formed using an ALD method and/or a MOCVD method. However, the ALD method and/or the MOCVD method may have manufacturing process problems and limitations in technical construction. There may be a difficulty in manufacturing the phase change material using the ALD method and the MOCVD method. For example, a metal-organic precursor, which may be used at a relatively low temperature, e.g., about 300 °C or less, may be difficult to develop.

### SUMMARY

Example embodiments provide a method of forming a phase change layer which may be formed in a confined structure and at room temperature, and may change between a crystalline state and an amorphous state relatively rapidly. Example embodiments also provide a method of manufacturing a storage node using the method of forming the phase change layer. Example embodiments also provide a method of manufacturing a phase change memory device using the method of manufacturing the storage node.

According to example embodiments, there is provided a method of forming a phase change layer, wherein the phase change layer may be formed using an electro-chemical deposition (ECD) method. The method may include forming an electrolyte by mixing a solvent and precursors, each precursor containing an element of the phase change layer, dipping an anode plate and a cathode plate in the electrolyte to be spaced apart from each other, wherein the cathode plate is a substrate on which the phase change layer is to be deposited, setting deposition conditions of the phase change layer, and supplying a voltage between the anode plate and the cathode plate.

The phase change layer may be one selected from the group consisting of: a layer comprising at least two different elements selected from the group consisting of Ge, Sb, and Te; an In-Sb-Te layer, and a Ge-Bi-Te layer. The precursors may comprise at least two selected from the group consisting of a Ge precursor, an Sb precursor, and a Te precursor, and the Ge precursor may be one selected from the group consisting of germanium oxide, germanium chloride, germanium bromide, germanium iodide, germanium sulfate and germanium sulfide.

The Sb precursor may be one selected from the group consisting of antimony oxide, antimony chloride, antimony bromide, antimony iodide, antimony sulfate and antimony sulfide. The Te precursor may be one selected from the group consisting of tellurium oxide, tellurium chloride, tellurium bromide, tellurium iodide, tellurium sulfate and tellurium sulfide. The precursors may be halide precursors. The halide precursors may be one selected from the group consisting of GeCl₄, SbCl₃, TeCl₄, GeBr₄, SbBr₃, TeBr₄, Gel₄, Sbl₃, and Tel₄.

Alternately, the precursors may be oxide precursors. The oxide precursors may be GeO₂, Sb₂O₃, and TeO₂. Forming the electrolyte may include adding a chelating agent to the electrolyte. A surface of the substrate on which the phase change layer is to be deposited, may be covered with one of an Au layer, a Pt layer, a Ti layer, a Ta layer, a TiN layer, a TaN layer, a W layer, a WN layer, a WT layer, and a TiAIN layer.

According to example embodiments, a method of manufacturing a storage node may include forming the phase change layer according to example embodiments on a bottom electrode, and forming a top electrode on the phase change layer. The method of manufacturing the storage node may further include annealing the phase change layer in order to crystallize the phase change layer after forming the phase change layer.

According to example embodiments, a method of manufacturing a phase change memory device may include forming a switching device on a substrate, and manufacturing the storage node according to example embodiments connected to the switching device.

### BRIEF DESCRIPTION OF THE DRAWINGS

Example embodiments will be more clearly understood from the following detailed description taken in conjunction with the accompanying drawings. FIGS. 1-11 represent non-limiting, example embodiments as described herein.
FIG. 1 is a cross-sectional view illustrating a structure of an electro-chemical deposition apparatus used in a method of forming a phase change layer according to example embodiments;
FIG. 2 illustrates cross-sectional views of the electro-chemical deposition apparatus of FIG. 1 illustrating a method of forming a phase change layer using an electro-chemical deposition method according to example embodiments;
FIG. 3 is a graph showing X-ray diffraction analysis of a Sb-Te phase change layer formed in a first experiment conducted by the inventors;
FIGS. 4 through 6 are scanning electronic microscope (SEM) images showing surfaces (upper part of the drawings) and cross-sections (lower part of the drawings) of a Sb-Te phase change layer formed in a second experiment using a basic aqueous solution as a solvent;
FIG. 7 is a graph showing characteristics of a Sb-Te phase change layer (Sb_{0.76}Te_{0.24}) having a eutectic composition in the second experiment;
FIGS. 8-10 are cross-sectional views illustrating a method of manufacturing a phase change memory device in which the method of forming the phase change layer of FIG. 2 is applied, according to example embodiments; and
FIG. 11 is a cross-sectional view of a storage node of a phase change memory device according to example embodiments.

It should be noted that these Figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. In particular, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION OF EXAMPLE EMBODIMENTS

Example embodiments will now be described more fully with reference to the accompanying drawings, in which example embodiments are shown. The thicknesses of layers or regions illustrated in the drawings are exaggerated for clarity of the present application. Like numbers refer to like elements.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

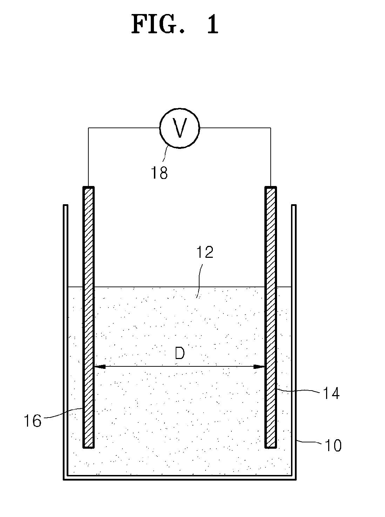

A method of forming a phase change layer according to example embodiments will be described. The phase change layer may be formed using an electro-chemical deposition method. FIG. 1 illustrates an electro-chemical deposition apparatus used in the method of forming a phase change layer according to example embodiments. Referring to FIG. 1, an electrolyte 12 may be filled in a container 10. The electrolyte 12 may be formed by mixing a solvent and a solute. An anode plate 14 and a cathode plate 16 may be installed in the container 10. The anode plate 14 and the cathode plate 16 may be separated a distance D from each other, and predetermined or given portions of the anode plate 14 and the cathode plate 16 may be dipped in the electrolyte 12.

A phase change layer may be deposited on the portion of the cathode plate 16 dipped in the electrolyte 12. Accordingly, a substrate, on which the phase change layer is deposited, may be the cathode plate 16. A surface of the substrate, on which the phase change layer is deposited, may be covered with one selected from the group consisting of Au, Pt, Ti, Ta, TiN, TaN, W, WN, WT, and TiAIN. Deposition of the phase change layer may begin when power is supplied from a power supply 18 connected to the anode plate 14 and the cathode plate 16. Before the deposition of the phase change layer, the anode plate 14 and the cathode plate 16 may not be connected to the power supply 18. The solvent may be an acid or basic aqueous solution and/or an organic solvent. The solute may be precursors including elements for forming a phase change layer. Accordingly, the solute may be various precursors according to the phase change layer to be formed. The solvent may be selected according to the solute.

When a phase change layer to be deposited includes at least two elements selected from the group consisting of Ge, Sb, and Te, for example, when the phase change layer is a Sb-Te layer or a Ge-Sb-Te layer, the solute may include at least two precursors selected from the group consisting of a Ge precursor, a Sb precursor, and a Te precursor. The Ge precursor may be one selected from the group consisting of germanium oxide, germanium chloride, germanium bromide, germanium iodide, germanium sulfate and germanium sulfide. For example, the Ge precursor may be one of GeO₂, GeCl₄, GeBr₄, and Gel₄.

The Sb precursor may be one selected from the group consisting of antimony oxide, antimony chloride, antimony bromide, antimony iodide, antimony sulfate and antimony sulfide. For example, the Sb precursor may be one selected from the group consisting of Sb₂O₃, SbCl₃, SbBr₃, and Sbl₄. The Te precursor may be one selected from the group consisting of tellurium oxide, tellurium chloride, tellurium bromide, tellurium iodide, tellurium sulfate and tellurium sulfide. For example, the Te precursor may be one selected from the group consisting of TeO₂, TeCl₄, TeBr₄, and Tel₄.

When the solute includes oxide precursors, for example, GeO₂, Sb₂O₃, and TeO₂, among the above listed precursors, the solvent may be an aqueous solvent or a polar solvent. The aqueous solvent may be one of an acid aqueous solution and a basic aqueous solution. The acid aqueous solution may be HCl, H₂SO₄, HNO₃, HClO₄ or H₂O₂. The basic aqueous solution may be KOH.

When the solute includes halide precursors among the above listed precursors, the solvent may be an organic solvent. The organic solvent may be one of ethylene glycol, propylene glycol, propylene carbonate, acetonitrile, toluene and ethylbenzene. The halide precursors may be one selected from the group consisting of (GeCl₄, SbCl₃, TeCl₄), (GeBr₄, SbBr₃, TeBr₄), and (Gel₄, Sbl₃, Tel₄).

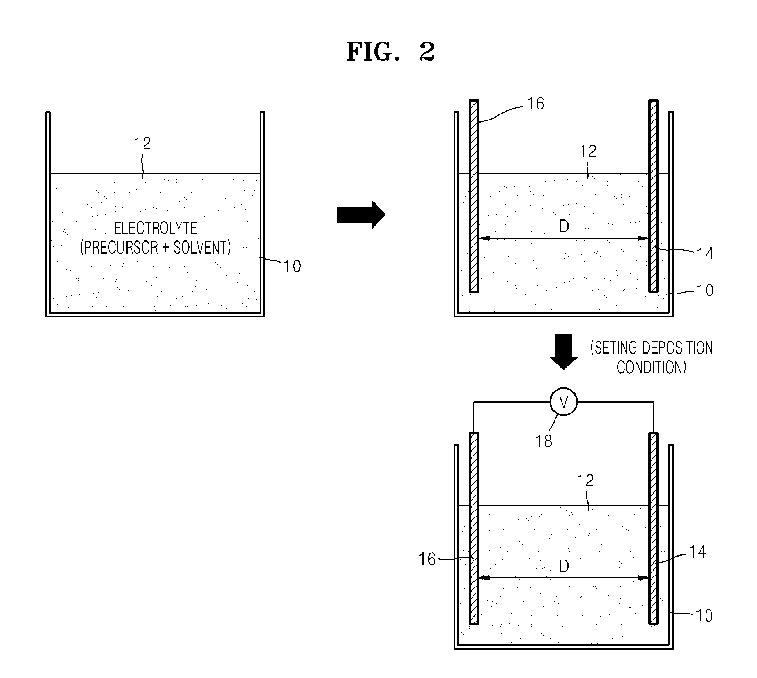

FIG. 2 illustrates cross-sectional views of the electro-chemical deposition apparatus of FIG. 1 illustrating a method of forming the phase change layer using an electro-chemical deposition method according to example embodiments. Referring to FIG. 2, source precursors of a phase change layer to be formed and a solvent suitable for these precursors may be mixed to form the electrolyte 12. The concentration of the precursors and the pH of the solvent may be controlled.

The electrolyte 12 may be filled in the container 10 to a given depth and the anode plate 14 and the cathode plate 16 may be dipped in the electrolyte 12. The distance D between the anode plate 14 and the cathode plate 16 may be controlled. The electrolyte 12 may be formed in the container 10 directly by mixing the precursors and the solvent in the container 10.

The deposition conditions are to be set. The deposition conditions are factors that may affect the deposition of the phase change layer, e.g., the temperature of the electrolyte 12, the agitating speed of the electrolyte 12, for example, the speed of stirring the electrolyte 12 during the deposition, the deposition time, the distance between the anode plate 14 and the cathode plate 16, the voltage applied between the anode plate 14 and the cathode plate 16, and the pH of the electrolyte 12. The temperature of the electrolyte 12 may be from a room temperature to about 100°C when the solvent may be an acid or basic aqueous solution, and may be from a room temperature to about 200°C when the solvent may be an organic solvent.

The voltage applied between the anode plate 14 and the cathode plate 16 may be about 0.1 V - about 2.5 V when the solvent may be an acid or basic aqueous solution, and may be about 1.0 V - about 4.0 V when the solvent may be an organic solvent. The power supply 18 may be connected to the anode plate 14 and the cathode plate 16 and a voltage according to the set deposition conditions may be applied between the anode plate 14 and the cathode plate 16 for the set time according to the deposition conditions.

Deposition experiments conducted by the inventors in the above-described sequence to form a phase change layer will be described. The inventors conducted first through fourth experiments. The cathode plate 16 was one of first through third substrates. The first substrate was a substrate on which a Si layer, a SiO₂ layer, a Ti layer, and, an Au layer were sequentially stacked. The second substrate was a substrate on which a Si layer, a SiO₂ layer, a Ti layer, and a TiN layer were sequentially stacked. The third substrate included a surface formed of Pt on which a phase change layer may be deposited.

An acid aqueous solution, namely H₂SO₄+HNO₃+HClO₄, was used as a solvent. A precursor including about 0.05 mol GeO₂, about 0.01 mol Sb₂O₃, and about 0.01 mol TeO₂ was used. The temperature of an electrolyte including the solvent and the precursor was maintained at the room temperature, and the pH of the electrolyte was maintained at less than about 7. A tartaric acid was added as a chelating agent to the electrolyte to help dissociation of the Sb₂O₃ precursor. The first or second substrate was used according to the voltage applied to the cathode plate 16.

A voltage of about 1.8 V was applied between the anode plate 14 and the cathode plate 16 for a first time to form a phase change layer. The first substrate was used as the cathode plate 16. The first substrate used as the cathode plate 16 was replaced with another new first substrate and the concentration and pH of the electrolyte were maintained. Then, a voltage of about 2.2 V was applied between the anode plate 14 and the cathode plate 16 for a second time to form a phase change layer. The first substrate used as the cathode plate 16 was replaced with the second substrate, and a voltage of about 2.2 V was applied between the anode plate 14 and the cathode plate 16 for a third time to form a phase change layer.

A basic aqueous solution, e.g., about 2 mol of KOH, was used as a solvent. The same precursor as the first experiment was used. The temperature of the electrolyte including the solvent and the precursors was maintained at room temperature, and the pH of the electrolyte was maintained to an appropriate value greater than about 7. A tartaric acid was added to the electrolyte for the same reason as the first experiment. The third substrate was used as the cathode plate 16.

Under the above conditions, a voltage of between about 0.3 V through about 0.7 V was applied between the anode plate 14 and the cathode plate 16 to form a phase change layer. When the voltage applied between the anode plate 14 and the cathode plate 16 was changed, the third substrate used as the cathode plate 16 was replaced with another new third substrate, and the concentration and pH of the electrolyte were maintained.

A basic aqueous solution, namely, 2 mol of KOH, was used as a solvent. 0.05 mol GeO₂, 0.01 mol Sb₂O₃, and 0.02 mol TeO₂ were used as precursors whereby the concentration of TeO₂ was increased by about 0.01 mol compared to the second experiment. The temperature of the electrolyte including the solvent and the precursors was maintained at room temperature, and the pH of the electrolyte was maintained to an appropriate value greater than about 7. A tartaric acid was added to the electrolyte for the same reason as in the first experiment. The third substrate was used as the cathode plate 16.

Under the above conditions, a voltage of between about 0.3 V through about 0.7 V was applied between the anode plate 14 and the cathode plate 16 to form a phase change layer. When the voltage applied between the anode plate 14 and the cathode plate 16 was changed, the third substrate used as the cathode plate 16 was replaced with another new third substrate, and the concentration and pH of the electrolyte were maintained. An organic solvent, e.g., propylene glycol, was used as a solvent. About 0.05 mol GeCl₄, about 0.01 mol SbCl₃, and about 0.01 mol TeCl₄ were used as precursors. The temperature of the electrolyte including the solvent and the precursors was maintained at the room temperature. The first substrate was used as the cathode plate 16.

Under the above conditions, a voltage of between about 1.0 V through about 3.5 V was applied between the anode plate 14 and the cathode plate 16 to form a phase change layer. When the voltage applied between the anode plate 14 and the cathode plate 16 was changed, the first substrate used as the cathode plate 16 was replaced with another new first substrate, and the concentration of the electrolyte was maintained.

Table 1 below shows the analysis of the compositions of the phase change layers formed in the first through fourth experiments. The analysis was obtained using inductive coupling plasma-atomic emission spectroscopy (ICP-AES).

**[Table 1]**

| Solvent | Potential (V) | substrate(Cathode) | Ge/(Ge+Sb+Te) | Sb/(Ge+Sb+Te) | Te/(Ge+Sb+Te) |
|---|---|---|---|---|---|
| Acid | 1.8 | Au | - | 0.431 | 0.568 |
| | 2.2 | Au | - | 0.462 | 0.536 |
| | 2.2 | TiN | - | 0.619 | 0.380 |
| Alkaline (I) | 0.3 | Pt | - | 0.759 | 0.239 |
| | 0.5 | Pt | - | 0.755 | 0.243 |
| | 0.7 | Pt | - | 0.758 | 0.241 |
| Alkaline (II) | 0.3 | Pt | - | 0.394 | 0.606 |
| | 0.5 | Pt | - | 0.399 | 0.601 |
| | 0.7 | Pt | - | 0.151 | 0.849 |
| Organic | 1.0 | Au | - | 0.111 | 0.889 |
| | 2.0 | Au | - | 0.282 | 0.718 |
| | 3.0 | Au | 0.121 | 0.332 | 0.547 |
| | 3.5 | Au | 0.124 | 0.360 | 0.516 |

In Table 1, Acid denotes the first experiment, Alkaline (I) denotes the second experiment, Alkaline (II) denotes the third experiment, and Organic denotes the fourth experiment.

Referring to Table 1, a Sb-Te based phase change layer was formed in the first through third experiments. In the first experiment, the greater the voltage, the greater the concentration of Sb and the lower the concentration of Te. In the second experiment, a Sb-Te based phase change layer (Sb_{0.76}Te_{0.24}) having a eutectic composition was formed. In the third experiment, at the voltages of about 0.3 V and about 0.5 V, respectively, a Sb-Te based phase change layer (Sb_{0.4}Te_{0.6}) was formed, which had an intermetallic compound composition. The conditions of the second and third experiments were the same except that the concentration of the TeO₂ precursor differed by about 0.01 mol. As may be noted from above and the results of the second and third experiments, the composition ratio (Sb/Te) of the deposited phase change layer may be more easily controlled by controlling the concentration of the precursors.

In the fourth experiment using the organic solvent, a Sb-Te based phase change layer was formed on a substrate at voltages of about 1.0 V and about 2.0 V. However, when the voltages were about 3.0 V and about 3.5 V, respectively, Ge-Sb-Te based phase change layers including about 12 % of Ge were formed on the substrate.

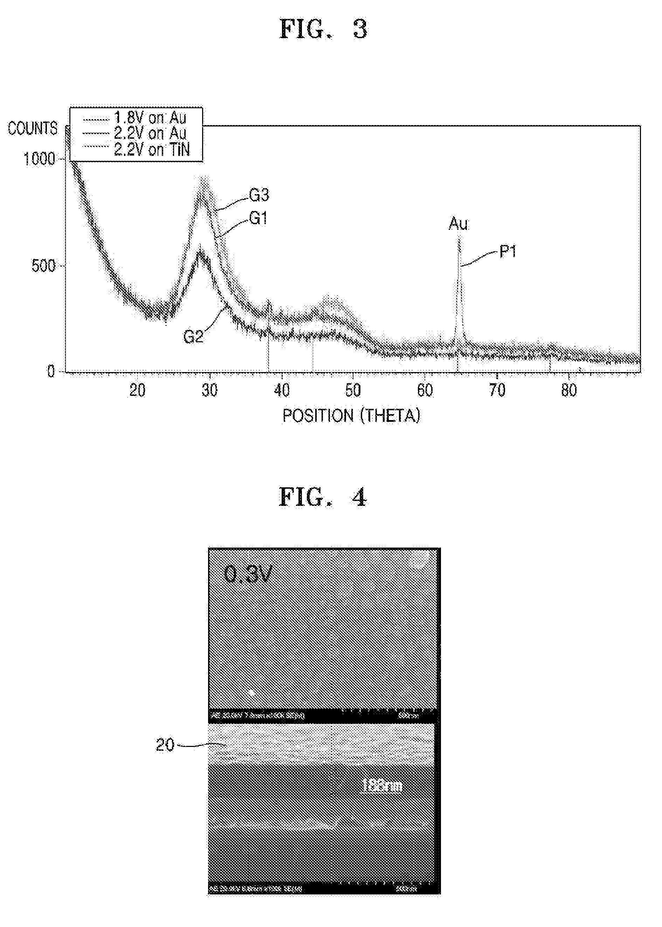

FIG. 3 is a graph showing X-ray diffraction analysis of the Sb-Te phase change layers formed in the first experiment. In FIG. 3, a first graph G1 shows the analysis of a Sb-Te phase change layer stacked on an Au layer at a voltage of about 1.8 V. A second graph G2 shows the analysis of a Sb-Te phase change layer stacked on an Au layer at a voltage of about 2.2 V. A third graph G3 shows the analysis of a Sb-Te phase change layer stacked on a TiN layer at a voltage of about 2.2 V. Referring to FIG. 3, all of the Sb-Te phase change layers formed in the first experiment have an amorphous structure. Accordingly, the Sb-Te phase change layer formed in the first experiment may be heated for crystallization. A sharp peak P1 in FIG. 3 may be due to the Au layer used as the substrate.

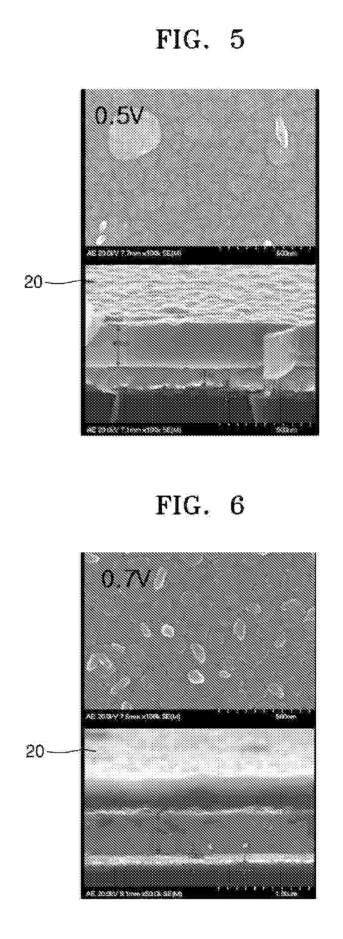

FIGS. 4 through 6 are scanning electronic microscope (SEM) images showing surfaces of Sb-Te phase change layers 20 (upper part of the drawings) and cross-sections of the substrate (lower part of the drawings) formed in a second experiment using a basic aqueous solution as a solvent. FIG. 4 is a SEM image of a Sb-Te phase change layer 20 formed at a voltage of about 0.3 V. FIG. 5 is a SEM image of a Sb-Te phase change layer 20 formed at a voltage of about 0.5 V, and FIG. 6 is a SEM image of a Sb-Te phase change layer 20 formed at a voltage of about 0.7 V.

Referring to FIGS. 4 through 6, the planarization degree of the Sb-Te phase change layers 20 may be improved, and the thickness thereof may be relatively uniform. The deposition speed was about 19, about 25, and about 47 nm/min at about 0.3 V, about 0.5 V, and about 0.7 V, respectively. For example, the grain size of the Sb-Te phase change layer 20 formed at about 0.3 V may be as small as about 50 nm.

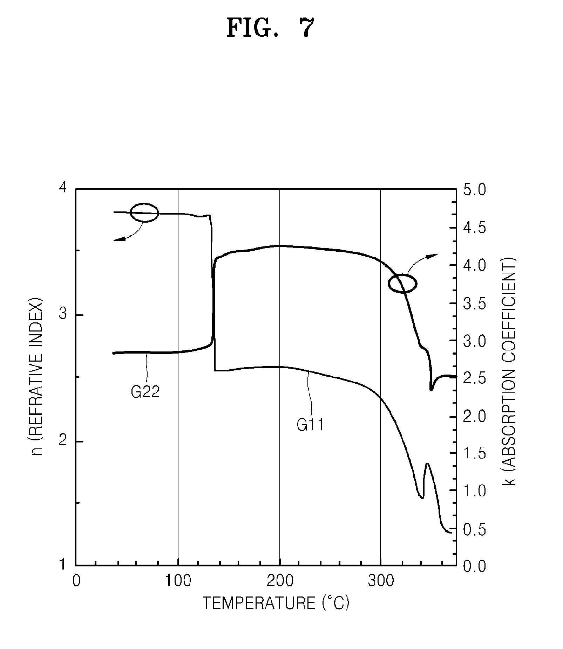

FIG. 7 is a graph showing characteristics of a Sb-Te phase change layer (Sb_{0.76}Te_{0.24}) having a eutectic composition in the second experiment, measured by ellipsometry. In FIG. 7, a first plot G11 shows the refractive index-temperature relationship of the Sb-Te phase change layer having a eutectic composition, and a second plot G22 shows the absorption coefficient-temperature relationship.

Referring to FIG. 7, at about 140°C, the refractive index and the absorption coefficient of the Sb-Te phase change layer having the eutectic composition may be changed more abruptly. The crystalline state of the Sb-Te phase change layer having the eutectic composition may be more abruptly changed from a crystalline state to an amorphous state whereby the rate of phase change is relatively high.

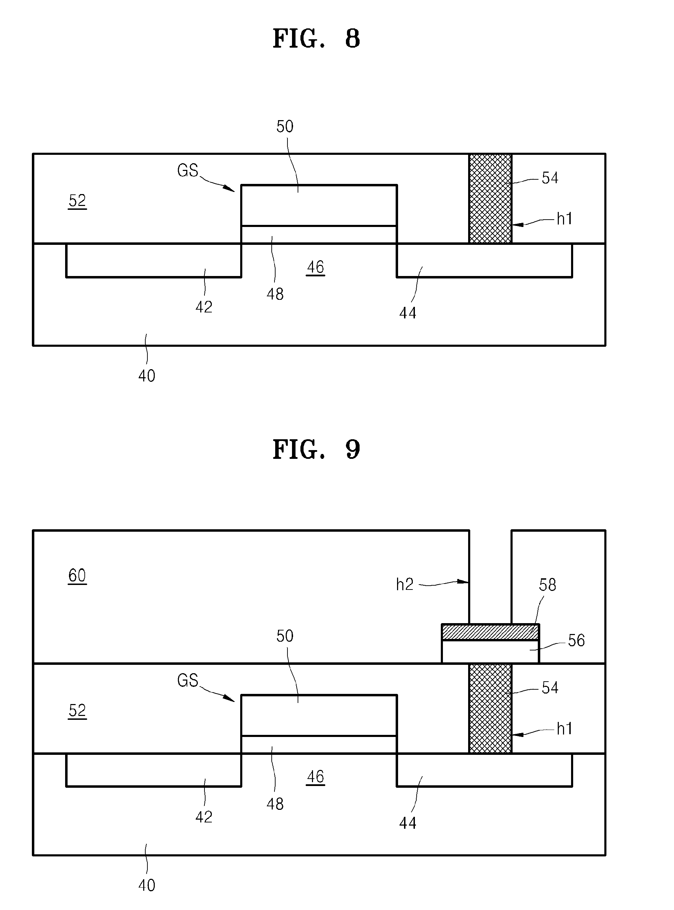

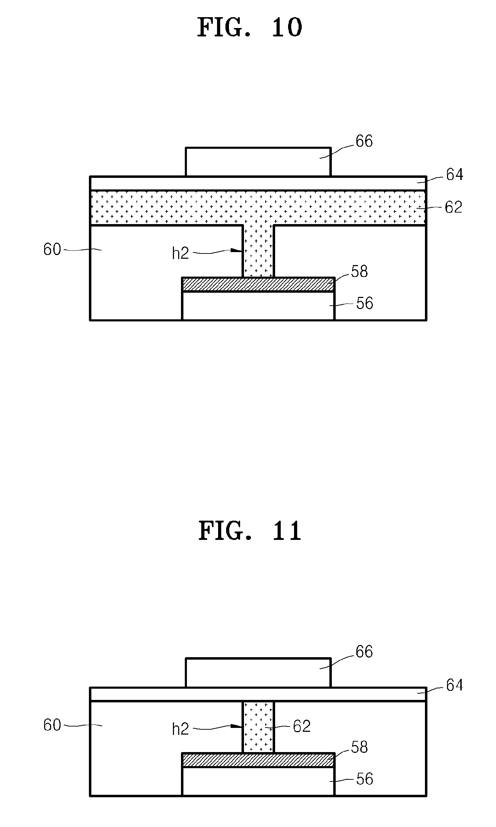

Hereinafter, a method of manufacturing a phase change memory device in which the method of forming a phase change layer is applied will be described. FIGS. 8-10 are cross-sectional views illustrating a method of manufacturing a phase change memory device in which the method of forming the phase change layer of FIG. 2 is applied, according to example embodiments, and FIG. 11 is a cross-sectional view of a storage node of a phase change memory device according to example embodiments.

Referring to FIG. 8, a gate stack (GS) may be formed on a portion of an active region of a substrate 40. The GS may be formed by sequentially stacking a gate insulating layer 48 and a gate electrode 50. A spacer (not shown) may be further formed on a side of the gate insulating layer 48 and the gate electrode 50. The GS may be used as a mask to inject a conductive impurity opposite to that of the conductive impurity of the substrate 40, for example, n-type impurity, to the active region of the substrate 40. First and second impurity regions 42 and 44 may be formed in the substrate 40 having the GS therebetween. The first and second impurity regions 42 and 44 and the GS may form a transistor which is one of switching devices. A region below the gate insulating layer 48 of the substrate 40 may be a channel region 46.

A first insulating interlayer 52 covering the transistor may be formed on the substrate 40. The first insulating interlayer 52 may be formed of a dielectric material, e.g., SiOₓ or SiOₓNy. A first contact hole h1 exposing the second impurity region 44 may be formed in the first insulating interlayer 52. A conductive material may be filled in the first contact hole h1 to form a conductive plug 54.

Referring to FIG. 9, a bottom electrode 56 covering an exposed upper surface of the conductive plug 54 may be formed on the first insulating interlayer 52, and a bottom electrode contact layer 58 may be formed on the bottom electrode 56. The bottom electrode 56 may be formed of TiN or TiAIN. Alternately, the bottom electrode 56 may be formed of a silicide including at least one selected from the group consisting of Ag, Au, Al, Cu, Cr, Co, Ni, Ti, Sb, V, Mo, Ta, Nb, Ru, W, Pt, Pd, Zn, and Mg.

The bottom electrode contact layer 58 may be formed of one selected from the group consisting of Au, Pt, Ti, Ta, TiN, TaN, W, WN, WT, and TiAIN. A second insulating interlayer 60 covering the bottom electrode 56 and the bottom electrode contact layer 58 may be formed on the first insulating interlayer 52. The second insulating interlayer 60 may be formed of the same material or a different material from the first insulating interlayer 52. A second contact hole h2 exposing an upper surface of the bottom electrode contact layer 58 may be formed in the second insulating interlayer 60.

In FIGS. 10 and 11, layers below the second insulating interlayer 60 and the bottom electrode 56 are omitted for convenience of description. Referring to FIG. 10, a phase change layer 62 may be formed on the second insulating interlayer 60 to fill the second contact hole h2. The phase change layer 62 may be formed of a Ge-Sb-Te layer, an In-Sb-Te layer, or a Ge-Bi-Te layer. The phase change layer 62 may be formed of other phase change materials. For example, the phase change layer 62 may be formed of a two-element, three-element, or four-element chalcogenide material. The phase change layer 62 may be formed using the above-described method of forming a phase change layer. Accordingly, when forming the phase change layer 62, the resultant structure of FIG. 9 may be disposed at a position of the cathode plate 16 in FIG. 2 of an electro-chemical deposition apparatus, and a voltage may be applied between the bottom electrode contact layer 58 and the anode plate 14 in FIG. 2 of the electro-chemical deposition apparatus. After forming the phase change layer 62, the phase change layer 62 may be annealed to crystallize the phase change layer 62. The annealing may also be performed after forming a top electrode 66. After forming the phase change layer 62, a top electrode contact layer 64 may be formed on the phase change layer 62. The top electrode 66 may be formed on the top electrode contact layer 64. A storage node including the phase change layer 62 and electrodes formed above and below the phase change layer 62 may be formed, thereby completing a phase change memory device.

The phase change layer 62 may also be formed only in the second contact hole h2 as illustrated in FIG. 11 when forming the phase change layer 62 using the electro-chemical deposition apparatus. Though not illustrated in the drawings, the second contact hole h2 may not be filled with the phase change layer 62 in FIG. 10, but with the bottom electrode contact layer 58. As described above, example embodiments provide a method of forming a phase change layer using an electro-chemical deposition method. Accordingly, the phase change layer may be formed at room temperature, at an increased deposition rate, and to a uniform thickness.

The electro-chemical deposition method may be a type of wet deposition, a phase change material formed using the method according to example embodiments may be filled in a minute structure which requires improved step coverage and has an increased aspect ratio. Thus, a limited region, for example, a nano-sized contact hole, may be filled with a phase change material when forming a phase change layer of a phase change memory device. Accordingly, when a phase change layer is filled in a minute structure, the reset current may be reduced, and thus the size of a transistor may be reduced and the integration degree of the phase change memory device may be increased. The crystalline state of the phase change layer formed using the above-described method may be abruptly changed at about 140°C from a crystalline state to an amorphous state. This indicates that the rate of phase change of the phase change layer may be increased.

Because the surface roughness of the phase change layer according to example embodiments is less than that of phase change layers using other deposition processes, a chemical mechanical polishing (CMP) process, which is a subsequent process, may be applied more easily.

When using the electro-chemical deposition method, the composition of the phase change layer may be controlled by simply controlling the concentration of the precursors included in the electrolyte, and thus the composition of the phase change layer may be more easily controlled. The phase change layer may be more easily doped by simply adding a doping material to the electrolyte.

The electro-chemical deposition apparatus may not require expensive vacuum equipment as used for a physical vapor deposition (PVD) method, a metal organic chemical vapor deposition (MOCVD) method or an atomic layer deposition (ALD) method, and may allow manufacturing of the phase change memory device in a relatively large scale. The manufacturing cost of forming a phase change layer of a phase change memory device may be reduced.

While example embodiments have been particularly shown and described with reference to example embodiments thereof, example embodiments should be considered in descriptive sense only and not for purposes of limitation. For example, it will be understood by those of ordinary skill in the art that various changes in the structure of the storage node of example embodiments may be made. A PN diode may be included instead of a transistor. A method of manufacturing a phase change memory device including a phase change layer that is not described above may be applied while maintaining the above-described technical scope of example embodiments. Therefore, the scope of example embodiments is defined not by the detailed description of example embodiments but by the appended claims.

## Claims

1. A method of forming a phase change layer, wherein the phase change layer is formed using an electro-chemical deposition (ECD) method.

2. The method of forming a phase change layer of claim 1, comprising:
forming an electrolyte by mixing a solvent and precursors, each precursor containing an element of the phase change layer;
dipping an anode plate and a cathode plate in the electrolyte to be spaced apart from each other, wherein the cathode plate is a substrate on which the phase change layer is to be deposited;
setting deposition conditions of the phase change layer; and
supplying a voltage between the anode plate and the cathode plate.

3. The method of forming a phase change layer of claim 2, wherein the precursors comprise at least two selected from the group consisting of a Ge precursor, a Sb precursor, and a Te precursor, and the Ge precursor is one selected from the group consisting of germanium oxide, germanium chloride, germanium bromide, germanium iodide, germanium sulfate and germanium sulfide.

4. The method of forming a phase change layer of claim 3, wherein the Sb precursor is one selected from the group consisting of antimony oxide, antimony chloride, antimony bromide, antimony iodide, antimony sulfate and antimony sulfide.

5. The method of forming a phase change layer of claim 3 or 4, wherein the Te precursor is one selected from the group consisting of tellurium oxide, tellurium chloride, tellurium bromide, tellurium iodide, tellurium sulfate and tellurium sulfide.

6. The method of forming a phase change layer of any of claim 2 to 6, wherein the solvent is an aqueous solvent or a polar solvent, and wherein the aqueous solvent is one of an acid aqueous solution and a basic aqueous solution.

7. The method of forming a phase change layer of claim 6, wherein the acid aqueous solution comprises one selected from the group consisting of HCl, H₂SO₄, HNO₃, HClO₄, and H₂O₂.

8. The method of forming a phase change layer of claim 6 or 7, wherein the basic aqueous solution comprises KOH.

9. The method of forming a phase change layer of claim 6 or 7, wherein the solvent is an organic solvent.

10. The method of forming a phase change layer of claim 9, wherein the organic solvent is one of ethylene glycol, propylene glycol, propylene carbonate, acetonitrile, toluene and ethylbenzene.

11. The method of forming a phase change layer of claim 9, wherein the precursors are halide precursors.

12. The method of forming a phase change layer of claim 11, wherein the halide precursors are one selected from the group consisting of GeCl₄, SbCl₃, TeCl₄, GeBr₄, SbBr₃, TeBr₄, and Gel₄, Sbl₃, Tel₄.

13. The method of forming a phase change layer of any of claims 2 to 12 , wherein the precursors are oxide precursors.

14. The method of forming a phase change layer of claim 13, wherein the oxide precursors are GeO₂, Sb₂O₃, and TeO₂.

15. The method of forming a phase change layer of any of claim 2 to 14, wherein forming the electrolyte comprises adding a chelating agent to the electrolyte.

16. The method of forming a phase change layer of claim 15, wherein the chelating agent is a tartaric acid.

17. The method of forming a phase change layer of any of claim 2 to 16, wherein a surface of the substrate on which the phase change layer is to be deposited, is covered with one of an Au layer, a Pt layer, a Ti layer, a Ta layer, a TiN layer, a TaN layer, a W layer, a WN layer, a WT layer, and a TiAIN layer.

18. The method of forming a phase change layer of any preceding claim, wherein the phase change layer is one selected from the group consisting of: a layer comprising at least two different elements selected from the group consisting of Ge, Sb, and Te; an In-Sb-Te layer; and a Ge-Bi-Te layer.

19. A method of manufacturing a storage node comprising:
forming the phase change layer according to claim 1 on a bottom electrode; and
forming a top electrode on the phase change layer.

20. A method of manufacturing a phase change memory device comprising:
forming a switching device on a substrate; and
manufacturing the storage node according to claim 19 connected to the switching device.

21. The method of manufacturing the storage node of claim 19, further comprising:
annealing the phase change layer in order to crystallize the phase change layer after forming the phase change layer.
